# EUROPEAN PATENT APPLICATION

(11) **EP 2 383 613 A2**
(43) Date of publication of application: **02.11.2011**
(21) Application number: 11162534.9
(22) Date of filing: 15.04.2011
(51) Int. Cl.: G03F 7/20

(54) **Cleaning apparatus and cleaning method**

(30) Priority: 27.04.2010 JP 2010102521
(71) Applicant: CANON KABUSHIKI KAISHA, Ohta-ku Tokyo 146-8501 (JP)
(72) Inventor: Nakayama, Takahiro, Ohta-ku Tokyo (JP)
(74) Representative: Williamson, Brian

(57) **Abstract**

A cleaning apparatus for cleaning an object by supplying a hydrogen radical to the object includes a generation unit configured to generate the hydrogen radical by supplying gas to a heated catalyst, a limitation unit configured to limit supply of gas from the generation unit to the object, and an exhaust unit configured to exhaust gas around the catalyst without passing it through the object in a state where the supply of the gas is limited by the limitation unit.

## Description

### BACKGROUND OF THE INVENTION

### Field of the Invention

The present invention relates to a cleaning apparatus and a cleaning method for cleaning an object by supplying a hydrogen radical to the object, and a lithography apparatus that includes such a cleaning apparatus.

### Description of the Related Art

Concerning the lithography apparatus, Japanese Patent Application Laid-Open No. 2007-184577 discusses a configuration that cleans a part of the apparatus using a hydrogen radical. In the configuration discussed therein, the hydrogen radical is generated by supplying hydrogen-containing gas to a heated catalyst (e.g., tungsten heated to 1500 to 3000 kelvins). The generated hydrogen radical is supplied to a portion to be cleaned via a pipe and a flow-rate adjusting shutter.

However, the cleaning apparatus has the following problem. Specifically, an oxide on a catalyst surface evaporates when the catalyst is heated, and the evaporated oxide adheres to an inner wall of a supply path such as the pipe. The oxide that adheres to the inner wall reacts with the hydrogen radical, causing deactivation of the hydrogen radical. Water generated by the reaction then oxidizes the catalyst again.

This phenomenon is referred to as a Water Vapor Cycle (Langmuir Cycle). For example, when tungsten W is used as a catalyst, the following reactions occur:

WOₓ+2H (hydrogen radical)→H₂O+W

W+H₂O→WOₓ+H₂

When these reactions are repeated, supply efficiency of the hydrogen radical decreases because the hydrogen radical is continuously deactivated. The decreased supply efficiency of the hydrogen radical leads to a longer period of time necessary for cleaning. For example, in the case of the lithography apparatus, productivity (throughput) is reduced.

### SUMMARY OF THE INVENTION

The present invention is directed to a cleaning apparatus for cleaning an object by supplying a hydrogen radical to the object, which can reduce adhesion of an oxide to an inner wall of a supply path of the hydrogen radical.

The present invention in its first aspect provides a cleaning apparatus as specified in claims 1 to 6.

The present invention in its second aspect provides a pattern transfer apparatus as specified in claims 7.

The present invention in its third aspect provides a method of cleaning as specified in claims 8.

Further features and aspects of the present invention will become apparent from the following detailed description of embodiments with reference to the attached drawings.

### BRIEF DESCRIPTION OF THE DRAWINGS

The accompanying drawings illustrate embodiments, features, and aspects of the invention and, together with the description, serve to explain the principles of the invention.

Fig. 1 illustrates a cleaning apparatus according to a first embodiment of the present invention.

Fig. 2 illustrates a first modified example of the first embodiment.

Fig. 3 illustrates a second modified example of the first embodiment.

Fig. 4 illustrates a cleaning apparatus according to a second embodiment of the present invention.

Fig. 5 is a schematic diagram illustrating a configuration of an extreme-ultraviolet (EUV) exposure device.

Fig. 6 is a flowchart illustrating a cleaning method according to the first embodiment.

Fig. 7 is a flowchart illustrating a cleaning method according to the second modified example of the first embodiment.

### DESCRIPTION OF THE EMBODIMENTS

Various embodiments, features, and aspects of the invention will be described in detail below with reference to the drawings.

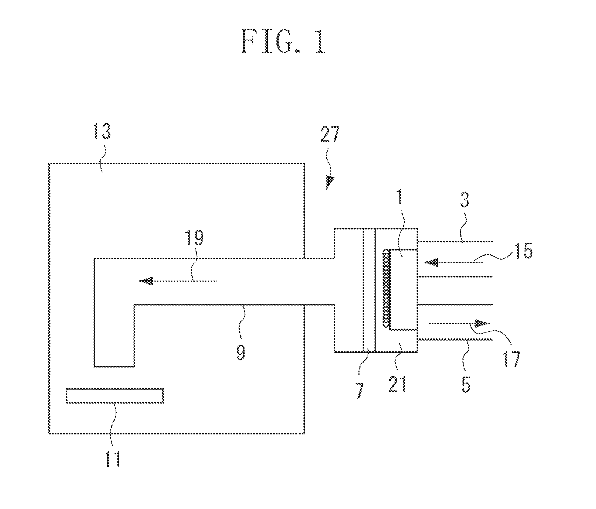

Fig. 1 is a schematic diagram illustrating a cleaning apparatus according to a first embodiment of the present invention. Illustrated Arrows indicate gas flows. A cleaning apparatus 27 cleans an object 11 by supplying a hydrogen radical to the object 11 to be cleaned. The cleaning apparatus 27 includes a hydrogen radical generation unit that generates a hydrogen radical by supplying gas to a heated catalyst. The hydrogen radical from the hydrogen radical generation unit is supplied to the object 11 via a pipe 9. The hydrogen radical generation unit includes a housing 21, a catalyst 1 arranged in the housing 21, a supply unit 3 that can supply gas to the catalyst 1, and a heating unit (not illustrated) that heats the catalyst 1.

The catalyst 1 enables generation of a hydrogen radical by reaction with the gas from the supply unit 3. The catalyst 1 contains, for example, at least one of tungsten, platinum, tantalum, molybdenum, nickel, and rhenium.

The supply unit 3 is configured to supply, to the catalyst 1, a gas that can generate a hydrogen radical by reaction with the catalyst 1. The supply unit 3 can also be configured to supply, to the catalyst 1, a reducing gas that can reduce an oxide of the catalyst 1. In this case, the supply unit 3 is only required to selectively supply two gases.

The gas that can generate the hydrogen radical by reaction with the catalyst 1 contains, for example, at least one of hydrogen and ammonia. The reducing gas contains, for example, at least one of a hydrogen radical, ethanol, carbon monoxide, methane, and propane. The gas from the supply unit 3 is advisably supplied to the vicinity of the catalyst 1.

The heating unit can heat the catalyst 1, and contains, for example, a power source for supplying a current to the catalyst 1. The "heating" includes a form of causing the catalyst itself to generate heat.

The cleaning apparatus 27 includes a shutter 7 (limitation unit) that can limit supplying of gas from around the catalyst 1 to the object 11, and an exhaust unit 5 that can exhaust the gas around the catalyst 1 without passing it through the object 11 in the gas-supply limited state by the shutter 7. The shutter 7 can be driven by a driving mechanism (not illustrated). A known technology can be applied to the driving mechanism. The limitation unit can be a gate valve.

The "gas-supply limited state by the shutter" includes not only a state where the shutter 7 completely blocks supplying of the gas but also a state where the shutter 7 limits supplying of the gas by reducing conductance of a gas supply path including the housing 21 and the pipe 9. Hereinafter, the case where the shutter 7 completely blocks supply of the gas is described. However, the present invention is not limited to this case.

In the present embodiment, the shutter 7 is arranged in the housing 21. However, the location of the shutter 7 is not limited to this. The shutter 7 is only required to be arranged between the catalyst 1 and the object 11. When arranged in the supply path 9, the shutter 7 is advisably arranged as close as possible to the catalyst 1.

The exhaust unit 5 is only required to exhaust the gas around the catalyst 1 without passing it through the object 11. For example, the exhaust unit 5 is arranged on a catalyst side with respect to the shutter 7.

In addition to the configuration described above at least a part of the supply unit 3, the exhaust unit 5, the pipe 9, the shutter 7, and the inner wall of the housing 21 can be made of a material that can suppress deactivation of the hydrogen radical. For example, a material such as SiO₂ where an annihilation probability of the hydrogen radical is 0.2 or less is applied. The annihilation probability of 0.2 of the hydrogen radical means that hydrogen atoms are annihilated by 90% when the hydrogen atoms collide with a surface of the material ten times.

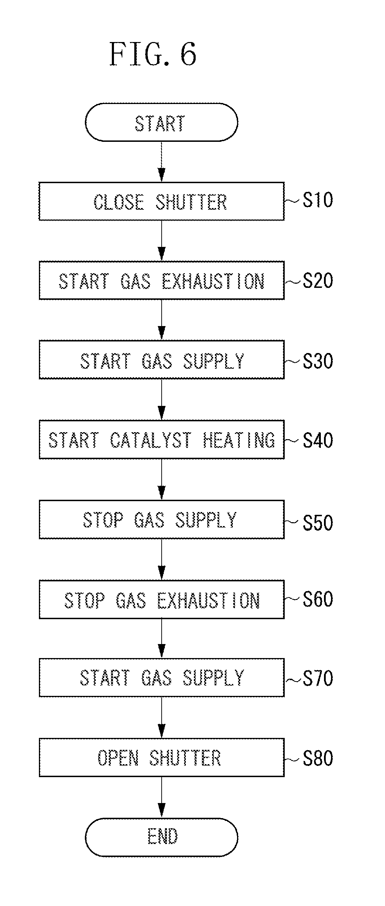

A cleaning method using the cleaning apparatus is described. Fig. 6 is a flowchart illustrating the cleaning method. Two examples of cleaning methods are described. One is a method of evaporating the oxide of the catalyst 1 while exhausting gas in a closed state of the shutter 7. The other is a method of reducing the oxide of the catalyst 1 while exhausting gas in the closed state of the shutter 7.

The former cleaning method is described. First, in step S10, the shutter 7 is closed. In step S20, the exhaust unit 5 starts exhaust of gas in the housing 21. This results in removal of gas present in the housing 21 and able to oxidize the catalyst 1.

In step S30, the supply unit 3 starts supplying of gas into the housing 21. As the gas to be supplied, for example, hydrogen is used. In step S40, the heating unit starts heating of the catalyst 1. In this housing, tungsten as the catalyst 1 is heated to 1100°C to 2000°C.

An oxide (tungsten oxide) present on a surface of the tungsten starts to evaporate at 1100°C or more, and hence the evaporated oxide is exhausted via the exhaust unit 5. In other words, the oxide can be prevented from adhering to an inner wall of the pipe 9. Oxidation of the tungsten can also be suppressed because H₂O able to oxidize the tungsten is exhausted.

Timing of steps S10 to S40 can arbitrarily be changed. The timing is only required to enable exhaust of the evaporated oxide.

Through steps S10 to S40, before a hydrogen radical is supplied to the object 11 to clean it, the supply unit 3 supplies hydrogen in the closed state of the shutter 7, and the exhaust unit 5 exhausts gas. After a passage of a predetermined period of time, in step S50, the supplying of gas by the supply unit 3 is stopped. This step can be omitted.

In step S60, the exhaust of the gas by the exhaust unit 5 is stopped. This step is executed to prevent the hydrogen radical generated during the cleaning from being exhausted without heading toward the object 11. Step S60 can be executed simultaneously with or after the start of the cleaning.

The processing then proceeds to cleaning of the object by the hydrogen radical. In step S70, the supply unit 3 starts supplying of hydrogen. In this case, the tungsten as the catalyst 1 is heated to 1600°C or more. The oxide on the tungsten surface has been removed in steps S10 to S40, hence the oxide can be prevented from evaporating from the tungsten surface and adhering to the inner wall of the supply path such as the pipe 9.

In step S80, the shutter 7 is opened to supply the generated hydrogen radical to the object 11, thereby performing cleaning.

After a predetermined period of time for the cleaning passes, the shutter 7 is closed to stop the supplying of the hydrogen radical, thereby completing the cleaning. When the hydrogen radical is continuously supplied to the object 11 on a steady basis, the cleaning can be stopped according to a cleaning stop command.

The latter cleaning method is described. First, in step S10, the shutter 7 is closed.

In step S20, the exhaust unit 5 starts exhaust of gas in the housing 21. This results in removal of gas present in the housing 21 which can oxidize the catalyst 1.

In step S30, the supply unit 3 starts supplying of gas into the housing 21. As the gas to be supplied, gas (reducing gas) that can reduce the oxide of the catalyst 1 is used. As such a gas, for example, gas containing at least one of a hydrogen radical, ethanol, carbon monoxide, methane, and propane is used. In step S40, the heating unit starts heating of the catalyst 1. In this case, tungsten as the catalyst 1 can be heated to 1100°C or less.

Step S20 can be executed simultaneously with or after step S30.

Through steps S10 to S40, before a hydrogen radical is supplied to the object 11 to clean it, the supply unit 3 supplies the hydrogen radical in a state where the shutter 7 is closed, and the exhaust unit 5 exhausts gas. After a predetermined period of time for reducing the oxide + of the catalyst 1 passes, in step S50, the supplying of the gas by the supply unit 3 is stopped. This step is executed to prevent the hydrogen radical generated during the cleaning and the reducing gas from mixing to damage the object 11. When damage by the reducing gas is sufficiently small which can be permitted, this step can be omitted.

In step S60, the exhaust of the gas by the exhaust unit 5 is stopped. This step is executed to prevent the hydrogen radical generated during the cleaning from being exhausted without heading toward the object 11. Step S60 can be executed simultaneously with or after the start of the cleaning.

The processing then proceeds to cleaning of the object by the hydrogen radical. In step S70, the supply unit 3 starts supplying of hydrogen. In this case, the tungsten as the catalyst 1 is heated to 1600°C or more. The oxide on the tungsten surface has been removed in steps S10 to S40, and hence the oxide can be prevented from evaporating from the tungsten surface and adhering to the inner wall of the supply path such as the pipe 9.

In step S80, the shutter 7 is opened to supply the generated hydrogen radical to the object 11, thereby performing cleaning.

After a predetermined period of time for the cleaning passes, the shutter 7 is closed to stop the supplying of the hydrogen radical, thereby completing the cleaning. When the hydrogen radical is continuously supplied to the object 11 on a steady basis, the cleaning can be stopped according to a cleaning stop command.

As a first modified example, in addition to the components described above, the cleaning apparatus 27 can include an inner wall heating unit that heats a part of the supply unit 3, the exhaust unit 5, the pipe 9, the shutter 7, and the housing 21.

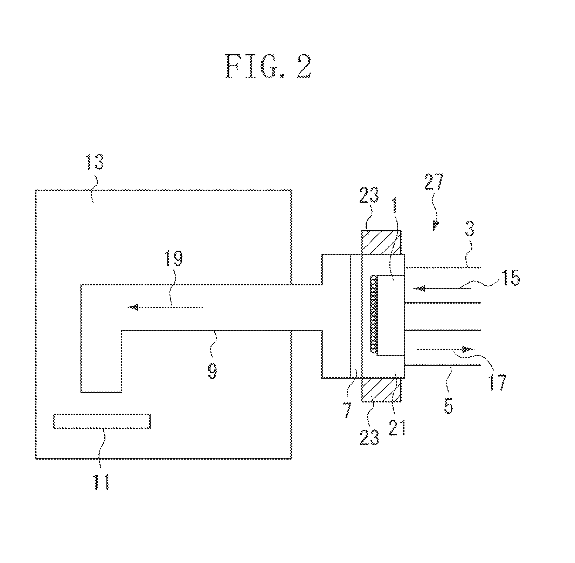

Fig. 2 illustrates a modified example of the cleaning apparatus that includes inner wall heating units 23 in the housing 21. For the inner wall heating units 23, for example, heaters such as ribbon heaters or wire heaters can be applied. The inner wall heating units 23 heat the housing 21 so that its temperature can become equal to or more than that around the cleaning apparatus, advisably 100°C or more.

When the oxide on the surface of the catalyst 1 evaporates, a part of the oxide may adhere to the inner wall of the housing 21 without being exhausted. In the present modified example, heating the inner wall to a high temperature by the inner wall heating units 23 prevents adhesion of the oxide, thereby suppressing deactivation of the hydrogen radical when the hydrogen radical collides with the inner wall.

While gas is supplied to the heated catalyst in the closed state of the shutter 7 and the exhaust unit 5 exhausts gas, the inner wall heating units 23 can heat the housing 21. However, timing of heating by the inner wall heating units 23 is not limited to this. The inner wall heating units 23 can perform heating during cleaning of the object 11.

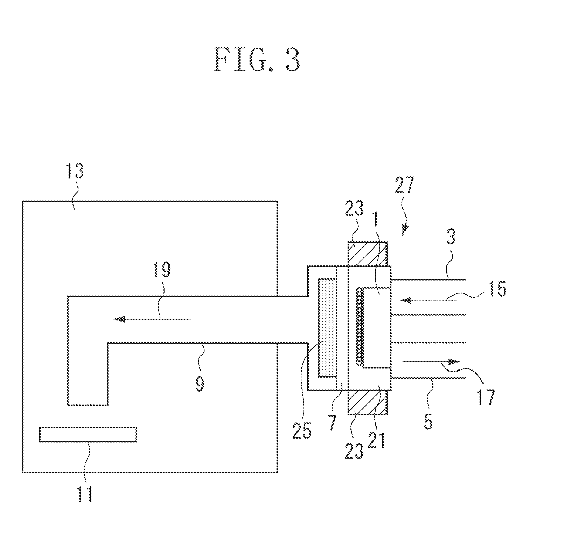

As a second modified example, in addition to the configuration of the first modified example, the cleaning apparatus 27 can include a cooling unit that cools the shutter 7. Fig. 3 illustrates a modified example of the cleaning apparatus that includes a cooling unit 25 on the shutter 7. The cooling unit 25 is configured to cool at least a part of the shutter 7. For the cooling unit 25, for example, a water-cooling system or a cooling method based on Peltier element can be applied. For example, the cooling unit 25 cools the shutter 7 so that its temperature can become equal to or less than that around the cleaning apparatus. This configuration enables a part of the unexhausted oxide to adhere to the surface of the shutter 7 when the oxide on the surface of the catalyst 1 evaporates. Promoting the adhesion of the oxide to the surface of the shutter 7 enables reduction of adhesion of the oxide to the inner wall of the housing 21.

In the present modified example, the shutter 7 is configured to retract from the supply path of the hydrogen radical. While gas is supplied to the heated catalyst in the closed state of the shutter 7 and the exhaust unit 5 exhausts gas, the cooling unit 25 can cool the shutter 7. Retracting the shutter 7 during cleaning of the object 11 prevents reduction of supply efficiency of the hydrogen radical caused by the oxide that has adhered to the shutter 7. The shutter 7 is not required to completely retract from a space including the supply path. It suffices that the shutter 7 can be driven in a manner that a surface of the shutter 7 to which the oxide has adhered does not face the space including the supply path.

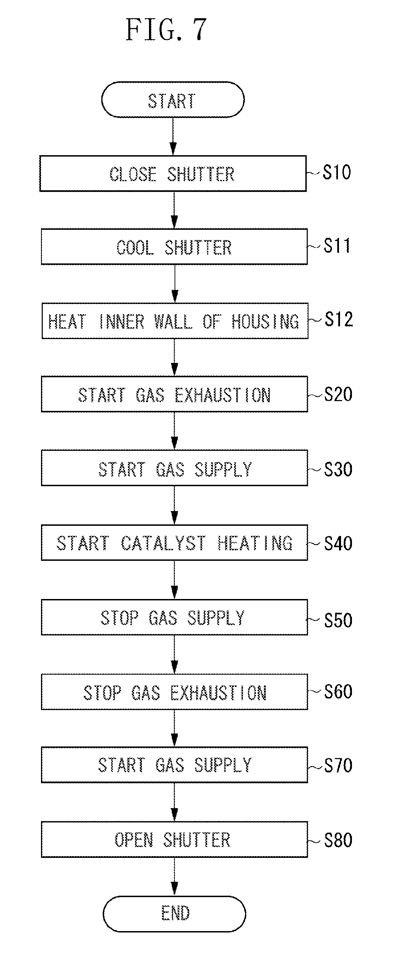

A cleaning method using the cleaning apparatus according to the modified example is described. Fig. 7 is a flowchart illustrating an example of a cleaning method. Steps similar to those illustrated in Fig. 6 have same reference numerals, and description thereof is omitted.

In the present modified example, in step S11, cooling of the shutter is started. Timing of step S11 is not limited to that illustrated in Fig. 7. For example, the cooling can be executed simultaneously with or before step S40.

In step S12, the inner wall heating units 23 start heating of the inner wall of the housing. Timing of step S12 is not limited to that illustrated in Fig. 7. For example, the heating can be executed simultaneously with or before step S40.

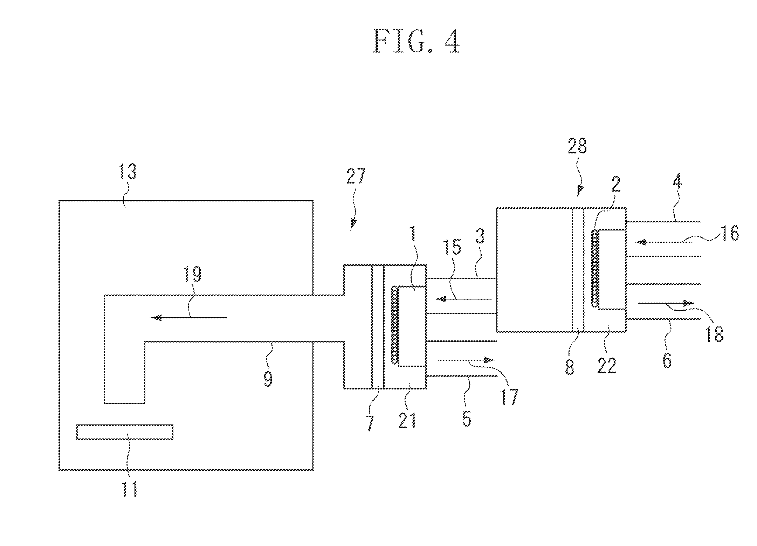

Fig. 4 is a schematic diagram illustrating a cleaning apparatus according to a second embodiment of the present invention. Illustrated arrows indicate gas flows. Portions having configurations and functions similar to those of the first embodiment have same reference numerals, and description thereof is omitted.

The second embodiment is different from the first embodiment in that a supply unit 3 includes a hydrogen radical generation unit 28 configured to supply a hydrogen radical. The hydrogen radical generation unit 28 can be similar in configuration to the hydrogen radical generation unit of the first embodiment.

The hydrogen radical generation unit 28 includes a housing 22, a catalyst 2 arranged in the housing 22, a supply unit 4 that supplies gas to the catalyst 2, and a heating unit (not illustrated) that heats the catalyst 2. The hydrogen radical generation unit 28 includes a shutter 8 (limitation unit) that can limit supply of a hydrogen radical to the supply unit 3, and an exhaust unit 6 that can exhaust gas around the catalyst 2 without passing it through a supply unit 3 when the shutter 8 limits the supply. A detailed configuration of these components is similar to that of the hydrogen radical generation unit of the first embodiment and description thereof is omitted.

A method of generating a hydrogen radical by the hydrogen radial generation unit 28 is similar to that of the first embodiment described above with reference to Fig. 6. The hydrogen radical generated by the hydrogen radical generation unit 28 is supplied as gas in step S30 of the cleaning method according to the first embodiment via the supply unit 3.

As an example, the cleaning apparatus is applied to a pattern transfer apparatus. The pattern transfer apparatus transfers a pattern to a substrate. The pattern transfer apparatus generally uses a particle beam such as light or an electron beam. The above cleaning apparatus is suitably used for a cleaning apparatus of an optical member that can control the particle beam. As an example, the cleaning apparatus is applied to an illumination optical unit or a projection optical unit of an EUV exposure device that uses extreme ultraviolet light having a wavelength of about 13 nanometers to transfer a pattern.

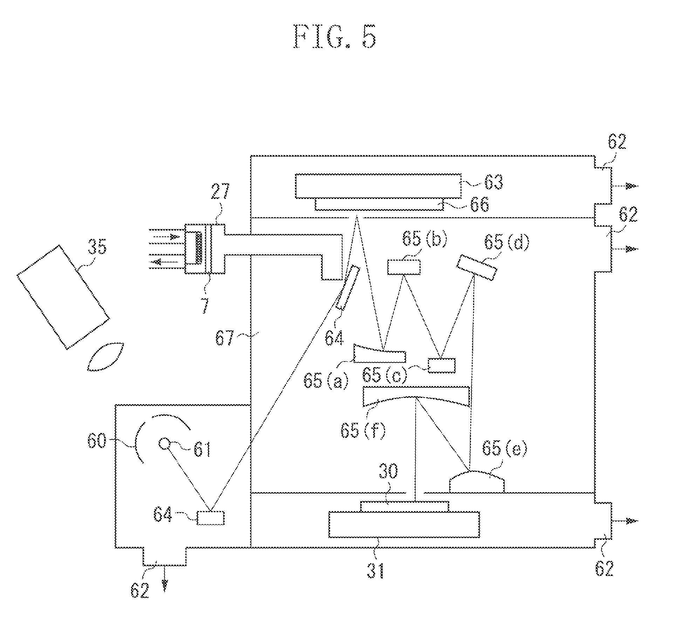

Fig. 5 schematically illustrates the EUV exposure device. The EUV exposure device transfers a pattern formed on a reticle (original plate) 66 to a wafer (substrate) by extreme ultraviolet light. The EUV exposure device includes a light source unit that generates extreme ultraviolet light, the illumination optical unit that guides the generated extreme ultraviolet light to the reticle, and the projection optical unit that guides the extreme ultraviolet light reflected on a surface of the reticle to the wafer. The EUV exposure device includes a wafer stage on which the wafer is moved, and a reticle stage on which the reticle is moved. These components are arranged in a container 67. The EUV exposure device further includes an exhaust unit such as a vacuum pump configured to generate a vacuum environment (e.g., pressure of 1 Pa or less) in the container 67 by performing exhaust via an exhaust port 62.

The light source unit includes a laser 35, a light emitting medium 61, and a condensing mirror 60. The light emitting medium 61 is irradiated with a laser beam from the laser 35 to extract the extreme ultraviolet light. The extracted ultraviolet light is condensed by the condensing mirror 60. The extreme ultraviolet light from the condensing mirror 60 is reflected by a multilayer film mirror 64 that serves as the illumination optical unit, and guided to the reticle 66.

The extreme ultraviolet light reflected on the surface of the reticle 66 is reflected by a multilayer film mirror 65 that serves as the projection optical unit, and guided to a wafer 30. The projection optical unit functions to project the pattern on the reticle onto the wafer in a reduced form.

In the EUV exposure device, a foreign object may adhere to the multilayer film mirror included in the illumination optical unit or the projection optical unit. Such a foreign object is, for example, carbon, which is caused by outgas discharged from the member included in the EUV exposure device or a carbon compound discharged from a resist (photosensitizing agent) applied on the wafer. Adhesion of the foreign object causes reduction of a reflectance ratio of the extreme ultraviolet light.

In the present embodiment, the EUV exposure device includes the cleaning apparatus 27. A hydrogen radical is supplied from the cleaning apparatus 27 to the multilayer film mirror, and reacts with the foreign object. As a result, the foreign object can be removed.

Fig. 5 illustrates the example of the cleaning apparatus that cleans the multilayer film mirror 64. However, the cleaning apparatus can be used for cleaning another optical element, or for cleaning members other than the optical elements. Cleaning can be performed when it is operating as a production apparatus or during maintenance when the cleaning apparatus does not operate.

According to the present embodiment, a period of time for cleaning can be shortened, and thus productivity (throughput) of the pattern transfer apparatus can be enhanced.

An example of a device manufacturing method that uses pattern transfer is described. As such a device, for example, a semiconductor device or a liquid crystal display device is manufactured. The semiconductor device is manufactured through a front-end process of fabricating an integrated circuit on the wafer and a back-end process of completing, as a product, the integrated circuit chip fabricated on the wafer in the front-end process. The front-end process includes a process of exposing the wafer on which the photosensitizing agent has been applied by the exposure device, and a process of developing the wafer. The back-end process includes an assembly process (dicing and bonding) and a packaging process (sealing). The liquid crystal display device is manufactured through a process of fabricating a transparent electrode. The process of fabricating the transparent electrode includes a process of applying a photosensitizing agent on a glass substrate on which a transparent conductive film has been deposited, a process of exposing the glass substrate on which the photosensitizing agent has been applied by the exposure device, and a process of developing the glass substrate. According to the present embodiment, the device manufacturing method enables manufacturing of a device higher in quality than a conventional one.

According to the present invention, in the cleaning apparatus that cleans the object by supplying the hydrogen radical to the object, adhesion of an oxide to the inner wall of the supply path of the hydrogen radical can be reduced.

While the present invention has been described with reference to embodiments, it is to be understood that the invention is not limited to the disclosed embodiments.

## Claims

1. A cleaning apparatus for cleaning an object (11) by supplying a hydrogen radical to the object, comprising:
a generation unit configured to generate the hydrogen radical by supplying gas to a heated catalyst (1);
a limitation unit (7) configured to limit supplying of gas from the generation unit to the object; and
an exhaust unit (5) configured to exhaust gas around the catalyst without passing it through the object (11) in a state where the supply of the gas is limited by the limitation unit (7).

2. The cleaning apparatus according to claim 1, further comprising:
a housing (21) configured to surround a space where the catalyst (1) is arranged; and
a heating unit configured to heat the housing.

3. The cleaning apparatus according to claim 1 or claim 2, further comprising a cooling unit configured to cool the limitation unit (7),
wherein the limitation unit (7) is retractable in a space separate from a space through which the hydrogen radical passes.

4. The cleaning apparatus according to claim 1, wherein the generation unit is configured to selectively supply, to the catalyst (1), first gas that can reduce an oxide adhering to a surface of the catalyst (1) and second gas that can generate a hydrogen radical when supplied to the heated catalyst (1).

5. The cleaning apparatus according to claim 4, wherein the first gas is a hydrogen radical.

6. The cleaning apparatus according to claim 5, further comprising:
a second generation unit configured to generate a hydrogen radical to be supplied to the catalyst by supplying gas to a heated second catalyst;
a second limitation unit arranged between the second generation unit and the catalyst (1) and configured to limit supply of gas from the second generation unit to the catalyst; and
a second exhaust unit configured to exhaust the gas around the second catalyst without passing it through the catalyst (1) in a state where the supplying of the gas is limited by the second limitation unit.

7. A pattern transfer apparatus for cleaning an optical member, the pattern transfer apparatus including a cleaning apparatus according to any one of claim 1 to claim 6.

8. A method of cleaning an object using a hydrogen radical generated by supplying gas to a heated catalyst, comprising:
exhausting gas from around the catalyst, while limiting the supply of gas from around the catalyst to the object;
simultaneously with exhausting said gas, removing an oxide from the catalyst by reducing or evaporating the oxide on a surface of the catalyst;
generating a hydrogen radical by supplying gas to the heated catalyst; and
removing the limitation in the gas supplied to the object so as to supply the generated hydrogen radical to the object.
